(19)

Europäisches
Patentamt
European
Patent Office
Office européen
des brevets

(11) **EP 3 624 239 A1**

(12) **EUROPEAN PATENT APPLICATION**

(43) Date of publication:
**18.03.2020 Bulletin 2020/12**

(21) Application number: **18193630.3**

(22) Date of filing: **11.09.2018**

(51) Int Cl.:
*H01M 4/36* (2006.01)          *C23C 16/44* (2006.01)
*C23C 16/455* (2006.01)     *H01M 4/505* (2010.01)
*H01M 4/525* (2010.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **BASF SE**
**67056 Ludwigshafen am Rhein (DE)**

(72) Inventors:
  • **Ahlf, Mareike**
    **67056 Ludwigshafen (DE)**
  • **Sommer, Heino**
    **67056 Ludwigshafen (DE)**
  • **Strempel, Verena**
    **67056 Ludwigshafen (DE)**
  • **Vogelsang, Regina**
    **67056 Ludwigshafen (DE)**
  • **Haag, Jacob**
    **Beachwood, OH 44122 (US)**
  • **Groner, Marcus Daniel**
    **Louisville, CO 80027 (US)**
  • **Gump, Christopher Jeffrey**
    **Louisville, CO 80027 (US)**
  • **Hall, Robert A.**
    **Denver, CO 80205-2917 (US)**
  • **Spencer II, Joseph Allen**
    **Longmont, CO 80503 (US)**

(74) Representative: **BASF IP Association**
     **BASF SE**
     **G-FLP-C006**
     **67056 Ludwigshafen (DE)**

(54)     **PROCESS FOR COATING AN OXIDE MATERIAL**

(57)     The present invention is related to a process for coating an oxide material, said process comprising the following steps:

(a) providing a particulate material selected from lithiated nickel-cobalt aluminum oxides, lithiated cobalt-manganese oxides and lithiated layered nickel-cobalt-manganese oxides,

(b) treating said cathode active material with a metal halide,

(c) treating the material obtained in step (b) with moisture,

and, optionally, repeating the sequence of steps (b) and (c),

wherein steps (b) and (c) are carried out in a mixer that mechanically introduces mixing energy into the particulate material, or by way of a moving bed or fixed bed, and wherein steps (b) and (c) are carried out at a pressure that is in the range of from 5 mbar to 1 bar above normal pressure.

**Description**

The present invention is related to a process for coating an oxide material, said process comprising the following steps:

(a) providing a particulate material selected from lithiated nickel-cobalt aluminum oxides, lithiated cobalt-manganese oxides and lithiated layered nickel-cobalt-manganese oxides,
(b) treating said cathode active material with a metal halide,
(c) treating the material obtained in step (b) with moisture,

and, optionally, repeating the sequence of steps (b) and (c),
wherein steps (b) and (c) are carried out in a mixer that mechanically introduces mixing energy into the particulate material, or by way of a moving bed or fixed bed, and wherein steps (b) and (c) are carried out at a pressure that is in the range of from 5 mbar to 1 bar above normal pressure.

Lithium ion secondary batteries are modern devices for storing energy. Many application fields have been and are contemplated, from small devices such as mobile phones and laptop computers through car batteries and other batteries for e-mobility. Various components of the batteries have a decisive role with respect to the performance of the battery such as the electrolyte, the electrode materials, and the separator. Particular attention has been paid to the cathode materials. Several materials have been suggested, such as lithium iron phosphates, lithium cobalt oxides, and lithium nickel cobalt manganese oxides. Although extensive research has been performed the solutions found so far still leave room for improvement.

One problem of lithium ion batteries lies in undesired reactions on the surface of the cathode active materials. Such reactions may be a decomposition of the electrolyte or the solvent or both. It has thus been tried to protect the surface without hindering the lithium ion exchange during charging and discharging. Examples are attempts to coat the surface of the cathode active materials with, e.g., aluminium oxide or calcium oxide, see, e.g., US 8,993,051.

The efficiency of the process, however, may still be improved. Especially in embodiments wherein the particles have a tendency to agglomerate the efficiency sometimes leaves room for improvement both in respect to reaction time and percentage of covered particles as well as percentage of coverage of particles.

It was therefore an objective of the present invention to provide a process by which particulate materials may be coated without an unduly long reaction time wherein such particulate materials have a tendency to form agglomerates. It was further an objective to provide a reactor for performing such a process.

Accordingly, the process as defined at the outset has been found, hereinafter also referred to as inventive process or as process according to the (present) invention. The inventive process is a process for coating a particulate material.

Coated materials as obtained in the context with the present invention refer to at least 80% of the particles of a batch of particulate material being coated, and to at least 75% of the surface of each particle being coated, for example 75 to 99.99 % and preferably 80 to 90%.

The thickness of such coating may be very low, for example 0.1 to 5 nm. In other embodiments, the thickness may be in the range of from 6 to 15 nm. In further embodiments, the thickness of such coating is in the range of from 16 to 50 nm. The thickness in this context refers to an average thickness determined mathematically by calculating the amount of metal halide per particle surface in $m^2$ and assuming a 100% conversion in steps (b) and (c).

Without wishing to be bound by any theory, it is believed that non-coated parts of particles do not react due to specific chemical properties of the particles, for example density of chemically reactive groups such as, but not limited to hydroxyl groups, oxide moieties with chemical constraint, or to adsorbed water.

In one embodiment of the present invention the particulate material has an average particle diameter (D50) in the range of from 3 to 20 $\mu$m , preferably from 5 to 16 $\mu$m. The average particle diameter can be determined, e. g., by light scattering or LASER diffraction. The particles are usually composed of agglomerates from primary particles, and the above particle diameter refers to the secondary particle diameter.

In one embodiment of the present invention, the particulate material has a specific surface, hereinafter also "BET surface" in the range of from 0.1 to 1.5 $m^2$/g. The BET surface may be determined by nitrogen adsorption after outgassing of the sample at 200°C for 30 minutes or more and beyond this accordance with DIN ISO 9277:2010.

The inventive process comprises three steps (a), (b) and (c), in the context of the present invention also referred to as step (a), step (b) and step (c).

Step (a) includes providing a particulate material selected from lithiated nickel-cobalt aluminum oxides, and lithiated cobalt-manganese oxide. Examples of lithiated layered cobalt-manganese oxides are $Li_{1+x}(Co_eMn_fM^4_d)_{1-x}O_2$. Examples of layered nickel-cobalt-manganese oxides are compounds of the general formula $Li_{1+x}(Ni_aCo_bMn_cM^4_d)_{1-x}O_2$, with $M^4$ being selected from Mg, Ca, Ba, Al, Ti, Zr, Zn, Mo, Nb, V and Fe, the further variables being defined as follows:

$$\text{zero} \leq x \leq 0.2$$

$$0.1 \leq a \leq 0.95,$$

$$\text{zero} \leq b \leq 0.5,$$

$$0.1 \leq c \leq 0.6,$$

$$\text{zero} \leq d \leq 0.1, \text{ and } a + b + c + d = 1.$$

In a preferred embodiment, in compounds according to general formula (I)

$$Li_{(1+x)}[Ni_aCo_bMn_cM^4{}_d]_{(1-x)}O_2 \qquad (I)$$

$M^4$ is selected from Ca, Mg, Al and Ba,

and the further variables are defined as above.

In $Li_{1+x}(Co_eMn_fM^4{}_d)_{1-x}O_2$, e is in the range of from 0.2 to 0.99, f is in the range of from 0.01 to 0.8, the variables $M^4$ and d and x are as defined above, and e + f + d = 1.

Examples of lithiated nickel-cobalt aluminum oxides are compounds of the general formula $Li[Ni_hCo_iAl_j]O_{2+r}$. Typical values for r, h, i and j are:

h is in the range of from 0.8 to 0.95,
i is in the range of from 0.015 to 0.19,
j is in the range of from 0.01 to 0.08, and
r is in the range of from zero to 0.4.

Particularly preferred are $Li_{(1+x)}[Ni_{0.33}Co_{0.33}Mn_{0.33}]_{(1-x)}O_2$, $Li_{(1+x)}[Ni_{0.5}Co_{0.2}Mn_{0.3}]_{(1-x)}O_2$, $Li_{(1,x)}[Ni_{0.6}CO_{0.2}Mn_{0.2}]_{(1-x)}O_2$, $Li_{(1,x)}[Ni_{0.7}CO_{0.2}Mn_{0.2}]_{(1-x)}O_2$, and $Li_{(1,x)}[Ni_{0.8}CO_{0.2}Mn_{0.2}]_{(1-x)}O_2$, each with x as defined above, and $Li[Ni_{0.88}Co_{0.065}Al_{0.055}]O_2$ and $Li[Ni_{0.91}Co_{0.045}Al_{0.045}]O_2$.

Said particulate material is preferably provided without any additive such as conductive carbon or binder but as free-flowing powder.

In one embodiment of the present invention particles of particulate material such as lithiated nickel-cobalt aluminum oxide or layered lithium transition metal oxide, respectively, are cohesive. That means that according to the Geldart grouping, the particulate material is difficult to fluidize and therefore qualifies for the Geldart C region. In the course of the present invention, though, mechanical stirring is not required in all embodiments.

Further examples of cohesive products are those with a flowability factor $ff_c \leq 7$, preferably $1 < ff_c \leq 7$ ($ff_c = \sigma_1 / \sigma_c$; $\sigma_1$ - major principle stress, $\sigma_c$ - unconfined yield strength) according to Jeni-ke or those with a Hausner ratio $f_H \geq 1.1$, preferably $1.6 \geq f_H \geq 1.1$ ($f_H = \rho_{tap} / \rho_{bulk}$; $\rho_{taP}$ - tapped density measured after 1250 strokes in jolting volumeter, $\rho_{bulk}$ - bulk density according to DIN EN ISO 60).

In step (b) of the inventive process, the particulate material provided in step (a) is treated with a metal halide. The treatment will be described in more detail below.

Steps (b) and (c) of the inventive process are performed in a vessel or a cascade of at least two vessels, said vessel or cascade - if applicable - also being referred to as reactor in the context of the present invention. Preferably, steps (b) and (c) are performed in the same vessel.

In one embodiment of the inventive process, step (b) is performed at a temperature in the range of from 15 to 1000°C, preferably 15 to 500°C, more preferably 20 to 350°C, and even more preferably 150 to 200°C. It is preferred to select a temperature in step (b) at which a significant amount of metal halide is in the gas phase.

Step (b) is carried out at a pressure above normal pressure. Thus, step (b) is carried out at a pressure in the range of from 5 mbar to 1 bar above normal pressure, preferably 10 to 150 mbar above normal pressure and more preferably 10 to 560 mbar above normal pressure. In the context of the present invention, normal pressure refers to ambient pressure. At sea level, normal pressure is $10^5$ Pa, but depending on the altitude of the place where the inventive process is performed, normal pressure may be lower. In a preferred embodiment, in step (b) the pressure is in the range of from 5 to 350 mbar above normal pressure.

Metal halides useful in step (b) are selected from those that can be transferred into the gaseous state at a temperature of less than 500°C, preferably less than 300°C at normal pressure, and/or which have a considerable vapour pressure at temperatures of less than 500°C. Metal halides include compounds of metals that have at least one halide as counteranion.

In a preferred embodiment of the present invention, metal halide is selected $M^1(R^1)X$, $M^2(R^1)_2X$, $M^2R^1X_2$, $M^3(R^1)_3X$, $M^3(R^1)_2X_2$, $M^3R^1X_3$ and compounds with two metal atoms per molecule such as, but not limited to $M^3_2X_6$, wherein

$R^1$ are different or equal and selected from hydride and $C_1$-$C_8$-alkyl, straight-chain or branched,

$M^1$ is selected from Mg and Zn,

$M^2$ is selected from Al and B,

$M^3$ is selected from Si, Sn, Ti, Zr, and Hf, with Sn and Ti being preferred,

X is selected from halide, for example fluoride, chloride, bromide or iodide, with fluoride being preferred and chloride being more preferred,

Examples of $M^2X_3$ and $M^3X_4$ and of compounds of $M^1$ or $M^2$ or $M^3$ with combinations of counterions are $AlCl_3$, $AlF_3$, $AlCl(CH_3)_2$, $AlCl_2CH_3$, $TiCl_4$, $TiI_4$, $TiF_4$, $ZrCl_4$, $ZrF_4$, $HfCl_4$, $HfOCl_2$, $SiCl_4$, $Si_2Cl_6$, $SiH_2Cl_2$, $(CH_3)_3SiCl$, $SiO_2$, $CH_3SiCl_3$, and $SnCl_4$. Particularly preferred is $TiCl_4$.

In one embodiment of the present invention, the amount of metal halide is in the range of 0.1 to 1 g/kg particulate material.

Preferably, the amount of metal halide is calculated to amount to 80 to 200% of a monomolecular layer on the particulate material per cycle.

In a preferred embodiment of the present invention, the duration of step (b) is in the range of from 1 second to 2 hours, preferably 1 second up to 10 minutes.

In a third step, in the context of the present invention also referred to as step (c), the material obtained in step (b) is treated with moisture.

In one embodiment of the present invention, step (c) is carried out at a temperature in the range of from 50 to 250°C.

Step (c) is carried out at a pressure above normal pressure. Thus, step (c) is carried out at a pressure in the range of from 5 mbar to 1 bar above normal pressure, preferably 10 to 50 mbar above normal pressure. In the context of the present invention, normal pressure is as defined in context with step (b).

Steps (b) and (c) may be carried out at the same pressure or at different pressures, preferred is at the same pressure.

Said moisture may be introduced, e.g., by treating the material obtained in accordance with step (b) with moisture saturated inert gas, for example with moisture saturated nitrogen or moisture saturated noble gas, for example argon. Saturation may refer to normal conditions or to the reaction conditions in step (c).

On one embodiment of the present invention, step (c) has a duration in the range of from 10 seconds to 2 hours, preferable 1 second to 10 minutes.

In one embodiment, the sequence of steps (b) and (c) is carried out only once. In a preferred embodiment, the sequence of steps (b) and (c) is repeated, for example once or twice or up to 50 times. It is preferred to carry out the sequence of steps (b) and (c) two to twenty times.

In a preferred embodiment of the present invention, step (c) is carried out in an atmosphere that is free from carbon dioxide. In the context of the present invention, "free from carbon dioxide" means that the respective atmosphere has a carbon dioxide content in the range of from 0.01 to 500 ppm by weight or even less, preferred are 0.1 to 50 ppm by weight or even less. The $CO_2$ content may be determined by, e.g., optical methods using infrared light. It is even more preferred to use an atmosphere with a carbon dioxide below detection limit for example with infrared-light based optical methods.

Steps (b) and (c) of the inventive process may be carried out continuously or batch-wise.

In one embodiment of the present invention, the reactor in which the inventive process is carried out is flushed or purged with an inert gas between steps (b) and (c), for example with dry nitrogen or with dry argon. Suitable flushing - or purging - times are 1 minute to 3 hours, preferably 10 minute to 2 hours. It is preferred that the amount of inert gas is sufficient to exchange the contents of the reactor of from one to 15 times. By such flushing or purging, the production of by-products such as separate particles of reaction product of metal halide with water can be avoided. In the case of the couple $TiCl_4$ and water, such by-products are hydrogen chloride and titania or $TiCl_4$ that is not deposited on the particulate material, titania being an undesired byproduct.

Various embodiments of reactor design are possible to perform the steps (b) and (c) of the inventive process.

Steps (b) and (c) are carried out in a mixer that mechanically introduces mixing energy into the particulate material, for example compulsory mixers and free-fall mixers. While free fall mixers utilize the gravitational forces for moving the particles compulsory mixers work with moving, in particular rotating mixing elements that are installed in the mixing room. In the context of the present invention, the mixing room is the reactor interior. Examples of compulsory mixers are ploughshare mixers, in German also called Lödige mixers, paddle mixers and shovel mixers. Preferred are plough-share mixers. Ploughshare mixers may be installed vertically or horizontally, the term horizontal or vertical, respectively, referring to the axis around which the mixing element rotates. Horizontal installation is preferred. Preferably, the inventive process is carried out in a ploughshare mixer in accordance with the hurling and whirling principle.

In another embodiment of the present invention, the inventive process may be carried out in a free fall mixer. Free fall mixers are using the gravitational force to achieve mixing. In a preferred embodiment, steps (b) and (c) of the inventive process are carried out in a drum or pipe-shaped vessel that rotates around its horizontal axis. In a more preferred embodiment, steps (b) and (c) of the inventive process are carried out in a rotating vessel that has baffles.

In one embodiment of the present invention a vessel or at least parts of it rotates with a speed in the range of from 5 to 500 revolutions per minute ("rpm"), preferred are 5 to 60 rpm. In embodiments wherein a free-fall mixer is applied, from 5 to 25 rpm are more preferred and 5 to 10 rpm are even more preferred. In embodiments wherein a plough-share mixer is applied, 50 to 400 rpm are preferred and 100 to 250 rpm are even more preferred.

In another embodiment of the present invention, steps (b) and (c) are carried out by way of a moving bed or fixed bed. In a fixed bed process, the particulate material provided in step (a) is placed upon a porous area, for example a sieve plate. Hereby, particulate material provided in step (a) forms a bed. In step (b) a medium, especially an inert gas containing a metal chloride flows from top to bottom through the bed, and in step (c), moisture, e.g., in the form of humid nitrogen or humid air, from bottom to top or from top to bottom through the bed.

In a moving bed process, particulate material provided in step (a) are introduced at the top of a tubular reactor, thereby automatically forming a particle bed. A gas stream containing a metal halide flows bottom-up through said bed with a gas velocity that is not sufficient to keep the particle bed in a steady state. Instead, the particle bed moves counter-currently with the gas stream (step (b). Step (c) is carried out accordingly but with moisture instead of metal halide.

In a preferred version of the present invention, which allows for the pneumatic conveying of said particulate material, a pressure difference up to 4 bar is applied. Coated particles may be blown out of the reactor or removed by suction.

In one embodiment of the present invention, the inlet pressure is higher but close to the desired reactor pressure. Pressure drops of gas inlet and in the moving or fixed bed, if applicable, have to be compensated.

In the course of the inventive process strong shear forces are introduced into the fluidized bed due to the shape of the reactor, for example in a moving bed or especially in a fluidized bed, the particles in the agglomerates are exchanged frequently, which allows for the accessibility of the full particle surface. By the inventive process, particulate materials may be coated in short time, and in particular cohesive particles may be coated very evenly.

In a preferred embodiment of the present invention the inventive process comprises the step of removing the coated material from the vessel or vessels, respectively, by pneumatic convection, e.g. 20 to 100 m/s.

In one embodiment of the present invention, the exhaust gasses are treated with water at a pressure above normal pressure and even more preferably slightly lower than in the reactor in which steps (b) and (c) are performed, for example in the range of from 2 mbar to 1 bar more than normal pressure, preferably in the range of from 4 mbar to 25 mbar above normal pressure. The elevated pressure is advantageous to compensate for the pressure loss in the exhaust lines.

The sealings necessary for separating the reactor and the exhaust gas treatment vessel from the environment are advantageously equipped with nitrogen flushing.

In one embodiment of the present invention, the gas inlet and the outlet are at opposite positions of the vessel used for the inventive process.

In one embodiment of the present invention, the coated oxide material obtained after step (c) is subjected to an after-treatment step (d), for example a thermal after-treatment at a temperature in the range of from 100 to 500°C at a pressure in the range of from 1 mbar to $10^5$ Pa over a period in the range of from 5 minutes to 5 hours.

By the inventive process, particulate materials may be coated in short time, and in particular cohesive particles may be coated very evenly. The inventive process allows for good safety because any combustible or even explosive atmosphere may be easily avoided.

The progress of the inventive process may be controlled by mass spectrometry. The inventive process is illustrated by the following working example.

Normal pressure: $10^5$ Pa.

sccm: standard cubic centimeter/min

I. Cathode active materials

1.1. Preparation of a precursor for cathode active materials

A stirred tank reactor was filled with deionized water. The precipitation of mixed transition metal hydroxide precursor was started by simultaneous feed of an aqueous transition metal solution and an alkaline precipitation agent at a flow rate ratio of 1.9, and a total flow rate resulting in a residence time of 8 hours. The aqueous transition metal solution contained Ni, Co and Mn at a molar ratio of 6:2:2 as sulfates each and a total transition metal concentration of 1.65 mol/kg. The alkaline precipitation agent consisted of 25 wt.% sodium hydroxide solution and 25 wt.% ammonia solution in a weight ratio of 25. The pH value was kept at 11.9 by separate feed of an aqueous sodium hydroxide solution. After stabilization of particle size the resulting suspension was removed continuously from the stirred vessel. The mixed transition metal (TM) oxyhydroxide precursor was obtained by filtration of the resulting suspension, washing with distilled water, drying at 120 °C in air and sieving.

1.2. Manufacture of cathode active materials

C-CAM.1 (Comparative): The mixed transition metal oxyhydroxide precursor obtained according to I.1 was mixed with $Al_2O_3$ (average particle diameter 6 nm) and LiOH monohydrate to obtain a concentration of 0.3 mole-% Al relative to Ni+Co+Mn+Al and a Li/(TM+Al) molar ratio of 1.03. The mixture was heated to 885°C and kept for 8 hours in a forced flow of oxygen to obtain the electrode active material C-CAM 1.

D50 = 9.5 $\mu$m determined using the technique of laser diffraction in a Mastersize 3000 instrument from Malvern Instruments. Al-content was determined by ICP analytics and corresponded to 820 ppm. Residual moisture at 250 °C was determined to be 300 ppm.

CAM.2 (inventive): A fluidized bed reactor with external heating jacket is charged with 100 g of C-CAM.1, and at an average pressure of 1030 mbar, C-CAM.1 is fluidized.

Step (b.1): The fluidized bed reactor is heated to 120 °C and kept at 120 °C for 3 hours. $TiCl_4$ in the gaseous state is introduced into the fluidized bed reactor through a filter plate by opening a valve to a precursor reservoir that contained $TiCl_4$ in liquid form and that is kept at 50° C. The $TiCl_4$ is diluted with nitrogen as carrier gas. The gas flow of $TiCl_4$ and $N_2$ is 10 sccm. After a reaction period of 210 seconds non-reacted $TiCl_4$ and HCl formed is removed through the nitrogen stream, and the reactor is purged with nitrogen for 105 minutes with a flow of 30 sccm.

Step (c.1): Then, the pressure was set to 1030 mbar. Water in the gaseous state was introduced into the fluidized bed reactor by opening a valve to a reservoir that contained liquid water kept at 24 °C, flow: 10 sccm. After a reaction period of 30 seconds non-reacted water is removed through a nitrogen stream, and the reactor is purged with nitrogen, 90 minutes at 30 sccm.

The sequence of steps (b.1) and (c.1) is repeated three times. Then, non-reacted water is removed through a nitrogen stream, and the reactor is purged with nitrogen, 90 minutes at 30 sccm.

Inventive coated oxide material CAM.2 is obtained. It has superior properties as cathode active material.

**Claims**

1. Process for making a coated oxide material, said process comprising the following steps:

   (a) providing a particulate material selected from lithiated nickel-cobalt aluminum oxides, lithiated cobalt-manganese oxides and lithiated layered nickel-cobalt-manganese oxides,
   (b) treating said cathode active material with a metal halide,
   (c) treating the material obtained in step (b) with moisture,

   and, optionally, repeating the sequence of steps (b) and (c),
   wherein steps (b) and (c) are carried out in a mixer that mechanically introduces mixing energy into the particulate material, or by way of a moving bed or fixed bed, and wherein steps (b) and (c) are carried out at a pressure that is in the range of from 5 mbar to 1 bar above normal pressure.

2. Process according to claim 1 wherein mixers are selected from compulsory mixers and free-fall mixers.

3. Process according to claim 1 or 2 wherein step (c) is carried out in an atmosphere that is free from carbon dioxide.

4. Process according to any of the preceding claims wherein metal halide is selected from $M^2X_3$, $M^3X_4$, $M^1(R^1)X$,

$M^2(R^1)_2X$, $M^2R^1X_2$, $M^3(R^1)_3X$, $M^3(R^1)_2X_2$, $M^3R^1X_3$, $M^3_2(R^1)_6$ and $M^3_2X_6$, wherein
$R^1$ are different or equal and selected from hydride and $C_1$-$C_8$-alkyl, straight-chain or branched,
$M^1$ is selected from Mg and Zn,
$M^2$ is selected from Al and B,
$M^3$ is selected from Si, Sn, Ti, Zr, and Hf,
X is selected from fluoride and chloride.

5. Process according to any of the preceding claims wherein lithiated layered nickel-cobalt-manganese oxide is a material of general formula (I)

$$Li_{(1+x)}[Ni_aCO_bMn_cM^4_d]_{(1-x)}O_2 \qquad (I)$$

wherein
$M^4$ is selected from Mg, Ca, Ba, Al, Ti, Zr, Zn, Mo, Nb, V and Fe,

$$zero \leq x \leq 0.2$$

$$0.1 \leq a \leq 0.95,$$

$$zero \leq b \leq 0.5,$$

$$0.1 \leq c \leq 0.6,$$

$$zero \leq d \leq 0.1,$$

and

$$a + b + c + d = 1.$$

6. Process according to any of the preceding claims wherein steps (b) and (c) are performed in a rotating vessel that has baffles.

7. Process according to any of the preceding claims wherein the metal halide is $TiCl_4$.

8. Process according to any of the preceding claims wherein the exhaust gasses are treated with water at a pressure above normal pressure.

9. Process according to claim 8 wherein the exhaust gasses are treated with water at a pressure in the range of from 5 mbar to 1 bar above normal pressure.

10. Process according to any of the preceding claims wherein particles of lithiated nickel-cobalt aluminum oxide or lithiated layered nickel-cobalt-manganese oxide, respectively, are cohesive.

11. Process according to any of the preceding claims wherein in step (b) the pressure is in the range of from 5 to 350 mbar above normal pressure.

12. Process according to any of the preceding claims wherein step (b) is performed at a temperature in the range of from 15 to 350°C.

13. Process according to any of the preceding claims wherein the reactor is flushed with an inert gas between steps (b) and (c).

**14.** Process according to any of the preceding steps comprising the step of removing the coated material from the vessel or vessels, respectively, by pneumatic convection.

Europäisches
Patentamt

European
Patent Office

Office européen
des brevets

# EUROPEAN SEARCH REPORT

**Application Number**

EP 18 19 3630

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/019627 A1 (BASF SE [DE]) 1 February 2018 (2018-02-01) | 1-5,7, 10-14 | INV. H01M4/36 |
| Y | * page 1, line 41 - page 2, line 15 * <br> * page 2, line 32 - page 3, line 4 * <br> * page 3, line 20 - line 21 * <br> * page 3, line 34 - line 36 * <br> * page 4, line 20 - line 38 * <br> * page 8, line 13 - page 9, line 31 * | 6,8,9 | C23C16/44 <br> C23C16/455 <br> H01M4/505 <br> H01M4/525 |
| Y | KR 2014 0006420 A (CN 1 CO LTD [KR]; UNIV SOGANG IND UNIV COOP FOUN [KR]) 16 January 2014 (2014-01-16) * Figures * | 6 | |
| Y | WO 2007/122418 A1 (EDWARDS LTD [GB]; BAILEY CHRISTOPHER MARK [GB]; GALTRY MICHAEL ANDREW) 1 November 2007 (2007-11-01) * page 7, line 23 - page 8, line 15 * | 8,9 | |
| Y | US 2017/207455 A1 (WATANABE HIROYASU [US] ET AL) 20 July 2017 (2017-07-20) * paragraphs [0013], [0016], [0019], [0020], [0031], [0055] - [0060], [0076] - [0078] * | 1,4,7, 10-13 | **TECHNICAL FIELDS SEARCHED (IPC)** <br> H01M <br> C23C |
| Y,D | US 8 993 051 B2 (TECHNISCHE UNIV. DELFT) 31 March 2015 (2015-03-31) * column 1, line 29 - line 41; claims 14,15 * * column 3, line 59 - line 65 * * column 4, line 50 - line 65 * | 1,4,7, 10-13 | |

The present search report has been drawn up for all claims

| Place of search | Date of completion of the search | Examiner |
|---|---|---|
| Munich | 7 February 2019 | Raimondi, Fabio |

EPO FORM 1503 03.82 (P04C01)

## ANNEX TO THE EUROPEAN SEARCH REPORT
## ON EUROPEAN PATENT APPLICATION NO.

EP 18 19 3630

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2019

| Patent document cited in search report | | | Publication date | Patent family member(s) | | | Publication date |
|---|---|---|---|---|---|---|---|
| WO 2018019627 | A1 | | 01-02-2018 | NONE | | | |
| KR 20140006420 | A | | 16-01-2014 | NONE | | | |
| WO 2007122418 | A1 | | 01-11-2007 | NONE | | | |
| US 2017207455 | A1 | | 20-07-2017 | CN | 109071266 | A | 21-12-2018 |
| | | | | EP | 3402750 | A1 | 21-11-2018 |
| | | | | KR | 20180121484 | A | 07-11-2018 |
| | | | | US | 2017207455 | A1 | 20-07-2017 |
| | | | | WO | 2017123836 | A1 | 20-07-2017 |
| US 8993051 | B2 | | 31-03-2015 | US | 2009155590 | A1 | 18-06-2009 |
| | | | | US | 2015162606 | A1 | 11-06-2015 |
| | | | | US | 2016226057 | A1 | 04-08-2016 |
| | | | | US | 2017282140 | A1 | 05-10-2017 |

EPO FORM P0459

For more details about this annex : see Official Journal of the European Patent Office, No. 12/82

**EP 3 624 239 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8993051 B